(19) Europäisches Patentamt / European Patent Office / Office européen des brevets

(11) **EP 2 197 117 B1**

(12) **EUROPÄISCHE PATENTSCHRIFT**

(45) Veröffentlichungstag und Bekanntmachung des Hinweises auf die Patenterteilung:
**31.07.2013  Patentblatt 2013/31**

(51) Int Cl.:
*H03M 1/10* *(2006.01)*     *H03M 1/66* *(2006.01)*

(21) Anmeldenummer: **08171356.2**

(22) Anmeldetag: **11.12.2008**

(54) **Schaltungseinheit zum Erzeugen einer Ausgangsspannung in Abhängigkeit von einem digitalen Datenwert und Verfahren zum Kalibrieren der Schaltungseinheit**

Switching unit for creating an output voltage depending on a digital data value and method for calibrating the switching unit

Unité de commutation destinée à produire une tension de sortie en fonction d'une valeur de données numérique et procédé de calibrage de l'unité de commutation

(84) Benannte Vertragsstaaten:
**DE FR GB IT**

(43) Veröffentlichungstag der Anmeldung:
**16.06.2010  Patentblatt 2010/24**

(73) Patentinhaber: **Siemens Aktiengesellschaft**
**80333 München (DE)**

(72) Erfinder: **Schwabe, Dietmar**
**08496 Neumark (DE)**

(56) Entgegenhaltungen:
**US-A- 4 222 107     US-A- 4 342 983**
**US-A1- 2005 001 747**

• **FALCONI ET AL: "Electronic interfaces" SENSORS AND ACTUATORS B, ELSEVIER SEQUOIA S.A., LAUSANNE, CH, Bd. 121, Nr. 1, 23. Januar 2007 (2007-01-23), Seiten 295-329, XP005856193 ISSN: 0925-4005**

**Beschreibung**

Die Erfindung betrifft eine Schaltungseinheit zum Erzeugen einer Ausgangsspannung in Abhängigkeit von einem digitalen Datenwert, wobei die Schaltungseinheit einen ersten Digital-Analog-Wandler (DAC - digital analog converter) und eine Einheit zum Verstärken umfasst. Die Erfindung betrifft auch ein Verfahren zum Kalibrieren der Schaltungseinheit.

Schaltungseinheiten zum Erzeugen eine Ausgangsspannung in Abhängigkeit von einem digitalen Datenwert werden beispielsweise in Reglern eingesetzt. Dabei wird in regelmäßigen Zeitabständen ein digitaler Datenwert einer Stellgröße mittels eines Algorithmus zum Regeln eines Prozesses berechnet. Anschließend wird dieser berechnete Datenwert in eine Ausgangsspannung gewandelt, um damit ein Stellglied zu steuern. Durch das so gesteuerte Stellglied wird ein Regelfehler im Prozess verringert. Die Schaltungseinheit zum Erzeugen der Ausgangsspannung in Abhängigkeit von dem digitalen Datenwert wird auch als analoge Ausgangsstufe eines (digitalen) Reglers bezeichnet.

Der Zusammenhang zwischen dem digitalen Datenwert, der einer Schaltungseinheit übergeben wird einerseits und der tatsächlich dazu erzeugten Ausgangsspannung andererseits wird Kennlinie der Schaltungseinheit genannt. Diese Kennlinie weicht in der Regel von einer theoretischen bzw. gewünschten Kennlinie ab. Dies kommt durch Toleranzen zustande, die bei Bauteilen der Schaltungseinheit und bei einer Fertigung der Schaltungseinheit hingenommen werden müssen.

Das Abweichen der Kennlinie einer Schaltungseinheit von der theoretischen Kennlinie hat beispielsweise bei Reglern die unerwünschte Folge, dass beim Steuern des Stellglieds mittels der Schaltungseinheit ein neuer Regelfehler in dem Prozess erzeugt wird.

Aus dem Stand der Technik ist dazu für heutige Regler bekannt, den digitalen Datenwert nicht direkt an die Schaltungseinheit zu übergeben, sondern zunächst mittels einer Abbildungsfunktion einen abgewandelten Datenwert zu berechnen. Bei diesem abgewandelten Datenwert ist dann die Abweichung der Kennlinie der analogen Ausgangsstufe von einer gewünschten Kennlinie berücksichtigt. Nachteil dieses Verfahrens ist, dass zusätzliche Rechenschritte zum Berechnen des abgewandelten Datenwerts nötig sind. Dies erfordert zusätzliche Rechenkapazität und zusätzliche Rechenzeit. Dadurch wird die maximal mögliche Änderungsrate der Ausgangsspannung in Abhängigkeit von regelmäßig erzeugten, digitalen Datenwerten begrenzt und damit die Möglichkeit, schnell veränderliche Prozesse zu regeln.

In dem Dokument US 4,342,983 ist ein dynamisch kalibrierbarer Digital-Analog-Wandler beschrieben, der eine gewöhnliche, digital steuerbare Stromquelle und eine zusätzliche Stromquelle umfasst. Die gewöhnliche, digital steuerbare Stromquelle weist eine fest vorgegebenen Kennlinie auf, die ungleichförmige Quantisierungsstufen aufweist. Durch Überlagern eines Ausgangsstroms der digital steuerbaren Stromquelle und eines Stromes der zusätzlichen Stromquelle ergibt sich in einem Summationspunkt eine Kennlinie des dynamisch kalibrierbaren Digital-Analog-Wandlers mit gleichförmiger Höhe der Quantisierungsstufen.

In dem Dokument US 2005/0001747 A1 ist ein System beschrieben, bei dem mittels eines Digital-Analog-Wandlers aus einem digitalen Eingangswert eine analoge Ausgangsspannung erzeugt wird. Mit Hilfe einer Kalibrierschaltung wird eine Korrekturspannung erzeugt, die über einen Summierer der Ausgangsspannung des Digital-Analog-Wandlers überlagert wird. Das Verhalten des Digital-Analog-Wandlers selbst ist dabei nicht kalib-rierbar. Die Korrekturspannung wird innerhalb der waubrierSchaltung durch einen zweiten Digital-Analog-Wandlers erzeugt.

In dem Artikel "Electronic interfaces" von Falconi et al. (Falconi et al.: "Electronic interfaces", ELSEVIER SEQUOIA S.A., LOUSANNE, CH, Bd. 121, Nr. 1, 23. Januar 2007, Seiten 295-329) ist eine Schaltung zum Messen eines Widerstandes eines Sensors beschrieben, wobei mittels der Schaltung ermöglicht wird, den Widerstand über eine große Spanne von möglichen Widerstandswerten digital zu messen. Um über die große Spanne eine genaue Messung des Widerstandswerts zu ermöglichen, kann ein Versorgungsstrom des Sensors durch Einstellen eines Vorwiderstands eines Digital-Analog-Wandlers variiert werden. Der Vorwiderstand wird durch Auswählen eines von mehreren Vorwiderständen eingestellt. Genauso kann eine Versorgungsspannung des Sensors über einen weiteren Digital-Analog-Wandler variiert werden. Die Digital-Analog-Wandler sowie die Vorwiderstände sind in ihrer Kennlinie nicht veränderbar und müssen vor Inbetriebnahme der Schaltung kalibriert worden sein.

Es ist daher Aufgabe der vorliegenden Erfindung, eine Möglichkeit bereitzustellen, mit der die Kennlinie einer analogen Ausgangsstufe an eine theoretische bzw. gewünschte Kennlinie möglichst einfach angepasst werden kann.

Die Aufgabe wird mit einer Schaltungseinheit gemäß Anspruch 1 gelöst. Die Aufgabe wird auch mit einem Verfahren gemäß Anspruch 5 gelöst. Des Weiteren gehört zu der Erfindung ein Regler gemäß Patentanspruch 7. Vorteilhafte Ausführungsformen der Erfindung sind durch die Unteransprüche gegeben.

Unter "skalieren" ist dabei zu verstehen, dass sich durch Verdoppeln der Referenzspannung auch die Amplitude des analogen Spannungssignals verdoppelt. Durch Bereitstellen einer zweiten steuerbaren Spannungsquelle lässt sich die Kennlinie der Schaltungseinheit in einer Weise festlegen, dass nicht nur eine Versatzspannung ausgeglichen wird, sondern unabhängig davon auch z.B. die Vollaussteuerung variiert werden kann.

Die zweite steuerbare Spannungsquelle ist bevorzugt ein dritter Digital-Analog-Wandler und der zweite Steuerwert für die zweite steuerbare Spannungsquelle entsprechend ein digitaler Steuerwert ist.

Mit einer solchen Vorrichtung mit einer Schaltungseinheit kann ein Abweichen der Kennlinie der Schaltungseinheit von einer theoretischen oder gewünschten Kennlinie mittels der ersten steuerbaren Spannungsquelle ausgeglichen werden. Dafür sind während des Betriebs der Schaltungseinheit keine zusätzlichen Rechenschritte notwendig. Anders als beim Stand der Technik kann eine Ausgangsspannung direkt auf Grundlage eines unveränderten digitalen Datenwerts erzeugt werden.

Dabei ist es insbesondere von Vorteil, wenn

- die erste steuerbare Spannungsquelle ein zweiter Digital-Analog-Wandler ist und
- der erste Steuerwert für die erste steuerbare Spannungsquelle ein digitaler Steuerwert ist.

Beispielsweise kann ein Controller eines Reglers eine Kennlinie der Schaltungseinheit im laufenden Betrieb durch Ausgeben von digitalen Steuerwerten selbständig an eine gewünschte Kennlinie anpassen.

Bevorzugt ist der erste Steuerwert für die erste steuerbare Spannungsquelle derart bestimmt, dass bei einem vorgegebenen minimalen digitalen Datenwert ein Betrag einer Differenz zwischen einem Istwert der Ausgangsspannung und einem Sollwert derselben kleiner als ein vorgegebener Wert ist.

Ein derartiger erster Steuerwert gleicht eine Versatzspannung (Offset) der Schaltungseinheit aus. Eine solche Versatzspannung verschiebt eine Kennlinie der Schaltungseinheit um einen konstanten Versatz gegenüber der theoretischen oder gewünschten Kennlinie. Der Sollwert der Ausgangsspannung ist dabei durch die gewünschte Kennlinie gegeben.

Der erste Steuerwert ist dabei derart bestimmt, dass sich die Kalibrierspannung Vkal durch folgende Gleichung in Abhängigkeit von einem Vollaussteuerungswert Vaf der Ausgangsspannung, einem Verstärkungsfaktor G der Einheit zum Verstärken, einem Wert für eine Übersteuerungsreserve R und einem Offsetfehlerwert Vaz der Schaltungseinheit ergibt:

$$Vkal = \frac{Vaf - (R+1) \cdot Vaz}{G \cdot R} \; .$$

Die resultierende Kennlinie einer kalibrierten Schaltungseinheit weicht dann für kleine digitale Datenwerte, insbesondere für den minimalen digitalen Datenwert, nicht von einer Kennlinie ab, die sich für eine Schaltungseinheit ohne Versatzspannung ergibt. Im Gegensatz zu einer einfachen Verschiebung der Kennlinie bleibt dabei jedoch der Vollaussteuerungswert der Schaltungseinheit unverändert.

Bei der Erfindung ist

- eine zweite steuerbare Spannungsquelle dazu ausgebildet, eine Referenzspannung in Abhängigkeit von einem zweiten Steuerwert zu erzeugen, und
- der erste Digital-Analog-Wandler dazu ausgebildet, eine Amplitude des analogen Spannungssignals in Abhängigkeit von der Referenzspannung zu skalieren.

Somit ergibt sich auch hier der bereits genannte Vorteil, dass die Kennlinie im Betrieb beispielsweise durch einen Controller automatisch angepasst werden kann.

Der zweite Steuerwert für die zweite steuerbare Spannungsquelle ist dabei derart bestimmt, dass sich die Referenzspannung Vref durch folgende Gleichung in Abhängigkeit von dem Vollaussteuerungswert Vaf der Ausgangsspannung, dem Verstärkungsfaktor G der Einheit zum Verstärken, dem Wert für die Übersteuerungsreserve R und dem Offsetfehlerwert Vaz der Schaltungseinheit ergibt:

$$Vref = \frac{Vaf - Vaz}{G \cdot R} \; .$$

Mit dem so bestimmten zweiten Steuerwert wird erreicht, dass der Vollaussteuerungswert bei Übergabe eines entsprechenden maximalen digitalen Datenwerts auch dann erreicht wird, wenn die Kennlinie der Schaltungseinheit derart verändert wurde, dass eine Versatzspannung der Schaltungseinheit ausgeglichen ist.

Eine besonders vorteilhafte Ausführungsform der Erfindung ergibt sich, wenn

- die Einheit zum Verstärken einen Differenzverstärker, insbesondere einen Operationsverstärker, umfasst, wobei ein Ausgang des Differenzverstärkers über einen Widerstand mit einem invertierenden Eingang des Differenzverstärkers verbunden ist, und
- die erste steuerbare Spannungsquelle über einen weiteren Widerstand mit dem invertierenden Eingang des Differenzverstärkers verbunden ist und
- der erste Analog-Digital-Wandler das analoge Spannungssignal an einem nicht-invertierenden Eingang des Differenzverstärkers anlegt.

Mit einer solchen Einheit zum Verstärken lässt sich besonders kostengünstig eine erfindungsgemäße Schaltungseinheit bereitstellen.

Die Aufgabe wird auch durch ein zur Erfindung gehöriges Verfahren zum Kalibrieren einer Schaltungseinheit gelöst, die mittels eines ersten Digital-Analog-wandlers und mittels einer Einheit zum Verstärken und in Abhängigkeit von einem digitalen Datenwert eine Ausgangsspannung erzeugt. Unter dem Begriff "Kalibrieren" ist dabei ein Anpassen der Kennlinie zu verstehen.

Dieses Verfahren kann automatisch von einem Controller beispielsweise bei Inbetriebnahme der Schaltungseinheit durchgeführt werden. Dadurch ist die Kennlinie der Schaltungseinheit an die gewünschte Kennlinie auch dann richtig angepasst, wenn sich das Übertragungsverhalten der Schaltungseinheiten z.B. in Folge von Alterung der Bauteile mit der Zeit ändert. Auch ein regelmäßiges Durchführen des Verfahrens während eines Betriebs der Schaltungseinheit ist möglich. Dadurch kann die Kennlinie der Schaltungseinheit auch dann angepasst werden, wenn sich das Übertragungsverhalten der Schaltungseinheit z.B. durch Erwärmen der Bauteile während eines Betriebs der Schaltungseinheit ändert. Es ist auch möglich, die Schritte 1) bis 4) bereits bei einer Herstellung der Schaltungseinheit durchzuführen und nur die Schritte 5) bis 8) bei jeder Inbetriebnahme oder während des Betriebs der Schaltungseinheit.

Dabei ergibt sich eine vorteilhafte Ausführungsform des Verfahrens durch die folgenden, weiteren Schritte:

9) Erfassen eines Temperaturwerts an der Schaltungseinheit,
10) Ändern der Kalibrierspannung und/oder der Referenzspannung in Abhängigkeit von dem Temperaturwert.

Da das Temperaturverhalten der Bauteile einen großen Einfluss auf das Übertragungsverhalten einer Schaltungseinheit hat, kann durch Änderung der Kalibrierspannung bzw. der Referenzspannung erreicht werden, dass die Kennlinie der Schaltungseinheit auch bei einer Änderung der Temperatur unverändert bleibt.

Die Erfindung umfasst auch einen Regler mit einer analogen Ausgabestufe, die eine erfindungsgemäße Schaltungseinheit umfasst. Zusätzlich oder alternativ dazu ist der Regler dazu ausgelegt, ein erfindungsgemäßes Verfahren zum Kalibrieren durchzuführen.

Der erfindungsgemäße Regler ist in der Lage, auch schnell veränderliche Prozesse präzise auf einen Sollzustand einzuregeln.

Die Erfindung wird im Folgenden anhand von Ausführungsbeispielen erläutert. Dazu zeigen:

FIG 1    einen Schaltplan einer Ausführungsform einer erfindungsgemäßen Schaltungseinheit;
FIG 2    ein Diagramm mit einer Kennlinie einer Schaltungseinheit, wobei die Kennlinie durch eine Ausführungsform eines erfindungsgemäßen Verfahrens angepasst wurde.

Die folgenden Beispiele stellen bevorzugte Ausführungsformen der Erfindung dar.

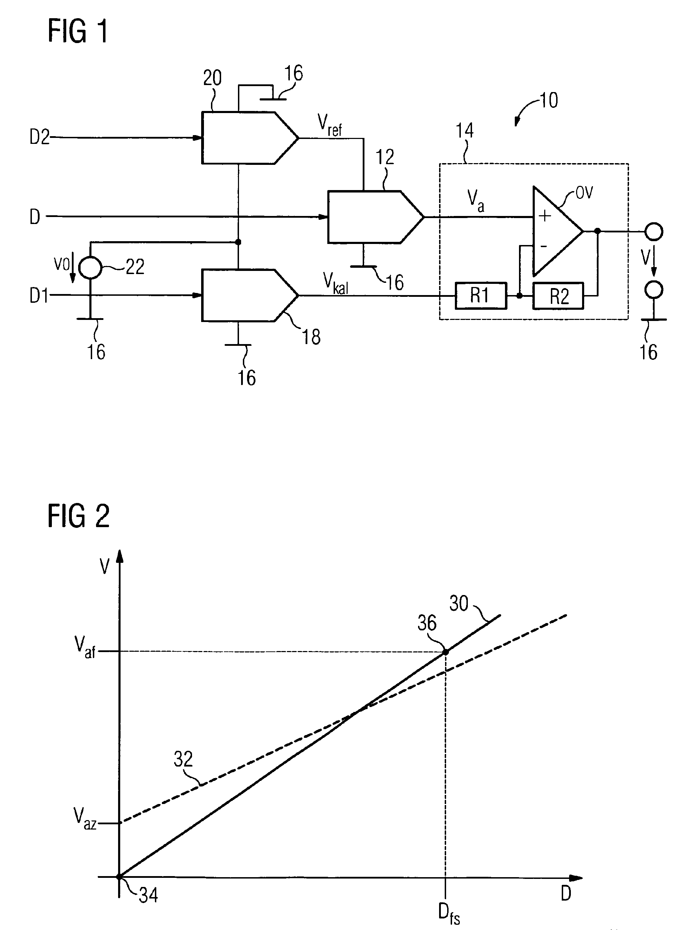

In dem Beispiel von FIG 1 weist eine Schaltungseinheit 10 einen ersten Digital-Analog-Wandler 12 und eine Verstärkerstufe 14 auf. Letztere stellt im Sinne der Erfindung eine Einheit zum Verstärken bereit. Die Verstärkerstufe 14 ist aus einem Oparationsverstärker OV und zwei Widerständen R1 und R2 gebildet.

Die Schaltungseinheit 10 ist hier Teil eines Reglers mit einem in FIG 1 nicht dargestellten Controller, der auf Grundlage eines Algorithmus zum Regeln digitale Datenwerte D erzeugt. Durch die Schaltungseinheit 10 wird ein in FIG 1 nicht dargestelltes Stellglied in Abhängigkeit von den Datenwerten D gesteuert. Die Schaltungseinheit 10 erzeugt dazu eine Ausgangsspannung V an einem Ausgang der Verstärkerstufe 14. Der Ausgang der Verstärkerstufe 14 ist mit einem Steuereingang des Stellglieds verbunden. Die Ausgangsspannung V der Verstärkerstufe 14 ist in dem gezeigten Beispiel unipolar, d.h. die Ausgangsspannung V hat hier immer einen Wert größer oder gleich 0 V.

Alle in FIG 1 angedeuteten Spannungen sind auf eine gemeinsame Masse 16 der Schaltungseinheit 10 bezogen.

Wird der Schaltungseinheit 10 ein Datenwert D übergeben, erzeugt der erste Digital-Analog-Wandler 12 ein zugehöriges analoges Spannungssignal Va, das an einem nicht-invertierenden Eingang des Operationsverstärkers OV anliegt. Die Verstärkerstufe 14 verstärkt das Spannungssignal Va dann auf die Ausgangsspannung V.

Die Verstärkerstufe 14 ist durch einen Verstärkungsfaktor G charakterisiert, um den das Spannungssignal Va verstärkt wird. Dieser Verstärkungsfaktor G wird durch die beiden Widerstände R1 und R2 bestimmt.

Das analoge Spannungssignal Va kann Spannungswerte zwischen wenigen Millivolt und einer Referenzspannung Vref des ersten Digital-Analog-Wandlers 12 annehmen. In dem vorliegenden Beispiel beträgt Vref gleich 2,5 V. Diesen Wert nimmt das Spannungssignal Va dann an, wenn der digitale Datenwert D seinen größtmöglichen Zahlenwert annimmt. Dieser Wert beträgt vorliegend $2^N-1$, wobei N die Wortlänge des Datenwerts D ist, also die Anzahl der Bits, die der Datenwert D insgesamt umfasst. Hier beträgt N=10, so dass der größtmögliche Wert einem dezimalen Wert von 1023 entspricht.

Den kleinsten Spannungswert nimmt das Spannungssignal Va dann an, wenn der digitale Datenwert D seinen kleinstmöglichen Zahlenwert angenommen hat. Dieser kleinstmögliche Wert ist hier der binäre Wert 0. Aufgrund von fertigungsbedingten Exemplarschwankungen erzeugt der erste Digital-Analog-Wandler 12 dabei nicht, wie theoretisch zu erwarten, ein Spannungssignal Va mit einer Amplitude von 0 V. Stattdessen weicht das Spannungssignal um eine Versatzspannung von einigen Millivolt von dem Wert 0 V ab. Auch der Operationsverstärker OV der Verstärkerstufe 14 weist einen Spannungsversatz von einigen Millivolt auf: Selbst bei einem Wert des Spannungssignals Va von 0 V würde dennoch am Ausgang der Verstärkerstufe 14 die Ausgangsspannung nicht 0 V betragen, wenn der Widerstand R1 wie bei einer vergleichbaren analogen Ausgangsstufe aus dem Stand der Technik direkt mit der Masse 16 verbunden wäre. Die Versatzspannungen des ersten Digital-Analog-Wandlers 12 und des Operationsverstärkers OV kumulieren sich dabei zu einer gesamten Versatzspannung der Schaltungseinheit 10.

Diese Versatzspannung wird durch eine Kalibrierspannung Vkal ausgeglichen, die von einem zweiten Digital-Analog-Wandler 18 bereitgestellt wird. Die Kalibrierspannung Vkal ist hier so bestimmt, dass sich eine Ausgangsspannung V von 0 V ergibt, wenn der digitale Datenwert D seinen kleinstmöglichen Zahlenwert annimmt. Der zweite Digital-Analog-Wandler 18 bildet damit im Sinne der Erfindung eine erste steuerbare Spannungsquelle, wobei der Spannungswert durch einen digitalen Steuerwert D1 steuerbar ist. Der Steuerwert D1 ist von dem Controller des Reglers erzeugt.

Auch die Referenzspannung Vref des Digital-Analog-Wandlers 12 ist von einem weiteren Digital-Analog-Wandler 20 bereitgestellt. Dieser stellt im Sinne der Erfindung eine zweite steuerbare Spannungsquelle dar, die von einem digitalen Steuerwert D2 steuerbar ist. Auch der Steuerwert D2 ist von dem Controller des Reglers erzeugt.

Eine Referenzspannung V0 der beiden Digital-Analog-Wandler 18 und 20 ist von einer weiteren Spannungsquelle 22 bereitgestellt. Diese Spannungsquelle 22 ist in FIG 1 lediglich durch ein Symbol dargestellt.

Indem der Controller die beiden digitalen Steuerwerte D1 und D2 festlegt, kalibriert er die Kennlinie der Schaltungseinheit 10, d.h. er bestimmt den Zusammenhang zwischen dem digitalen Datenwert D und der dazu erzeugten Ausgangsspannung V. Dadurch können die Datenwerte D direkt (also ohne Umrechnen wie im Stand der Technik) in den Digital-Analog-Wandler 12 geschrieben werden. Die gewünschte Kennlinie der Schaltungseinheit 10 ergibt sich direkt aus dem Wert der Kalibrierspannung Vkal und dem Wert der Referenzspannung Vref. Durch den Wegfall einer Berechnung von abgewandelten Datenwerten D, bei denen das Übertragungsverhalten der Schaltungseinheit berücksichtigt ist, ergibt sich eine verkürzte Rechenzeit des Controllers. Dies ermöglicht dem Controller eine höhere Ausgaberate von aufeinanderfolgenden Datenwerten. Des Weiteren kann die volle Auflösung des Digital-Analog-Wandlers 12 genutzt werden, da keine Berechnungsfehler zu Unstetigkeiten der Ausgangsspannung (z.B. Sprünge im zeitlichen Verlauf) führen.

Um die beiden Steuerwerte D1 und D2 festlegen zu können, ist in dem vorliegenden Beispiel durch den Hersteller die Kennlinie der nicht-kalibrierten Schaltungseinheit 10 mittels einer Ausführungsform eines erfindungsgemäßen Verfahrens zum Kalibrieren einer Schaltungseinheit ermittelt worden. Dazu wurde zunächst eine Kalibrierspannung Vkal von 0 V und eine Referenzspannung Vref von 2,5 V erzeugt. Anschließend wurde als Datenwert D ein minimaler Zahlenwert, d.h. vorliegend ein binärer Wert von 0, an die Schaltungseinheit 10 übergeben und der Wert der Ausgangsspannung V als Istwert eines Offsetfehlers Vaz erfasst. Dann wurde als Datenwert D der größtmögliche Zahlenwert $2^N-1$ übergeben. Die zu dem maximalen Zahlenwert erzeugte Ausgangsspannung V wurde als Istwert der Vollaussteuerung Vaf erfasst.

Aus der vom Hersteller durchgeführten Messung des Offsetfehlers Vaz und der Vollaussteuerung Vaf ergibt sich die Kennlinie der unabgeglichenen Schaltungseinheit 10. Für einen effektiven Betrieb des Reglers wird diese Kennlinie in eine ideale Kennlinie überführt. Als Sollwert bzw. Idealwert des Offsetfehlers ist ein Wert von Null gesetzt. Des Weiteren ist eine Übersteuerungsreserve R bereitgestellt, d.h. als ein maximaler Zahlenwert wird ein digitaler Fullscalewert Dfs bestimmt, der kleiner als der theoretische größtmögliche Zahlenwert $2^N-1$ ist. Zu dem Fullscalewert Dfs wird ein Faktor Dfv bestimmt, der ausdrückt, in welchem Maß der digitale Wertebereich des Datenwerts D ausgenutzt wird. Vorliegend ist der Faktor als $Dfv = 2 \cdot Dfs/2^N$ berechnet. Der Fullscalewert Dfs wird dabei so gewählt, dass der Faktor Dfv einen Wert größer als 1 und kleiner als 2 hat. Die Übersteuerungsreserve R ergibt sich dann vorliegend zu R=Dfv-1, so dass sich für die Übersteuerungsreserve R ein Wert zwischen 0 und 1 ergibt.

Die gesamte Schaltung wird also mittels der Übersteuerungsreserve R so ausgelegt, dass die Referenzspannung Vref einen bestimmten Betrag größer ist, als für eine Vollaussteuerung der Ausgangsstufe notwendig ist.

In Abhängigkeit von dem Offsetfehler Vaz und dem Vollaussteuerwert Vaf sind zunächst die benötigte Referenzspannung Vref und die benötigte Kalibrierspannung Vkal anhand von Gleichungen bestimmt, wie sie in einer Ausführungsform der Erfindung vorgegeben sind. Anschließend sind entsprechende Steuerwerte D1 und D2 in dem Controller gespeichert worden, so dass bei Inbetriebnahme des Reglers die gewünschte Kennlinie der Schaltungseinheit 10 automatisch durch den Controller eingestellt werden kann.

Durch die Übersteuerungsreserve R bzw. durch Bestimmen eines Fullscalewerts Dfs ergibt sich der vorteilhafte Effekt, dass die volle Auflösung des Digital-Analog-Wandlers 12 genutzt wird.

Der Controller ist zusätzlich in der Lage, die Steuerwerte D1 und D2 bei einer Änderung der Umgebungstemperatur der Schaltungseinheit 10 nachzuführen. Damit bleibt die Kennlinie der Schaltungseinheit 10 selbst dann unverändert, wenn sich das Betriebsverhalten des Digital-Analog-Wandlers 12, des Operationsverstärkers OV oder der Widerstände R1 und R2 wegen einer Erwärmung der Bauteile ändert. Ermöglicht wird ein korrektes Nachführen dadurch, dass die Temperatur in der Umgebung der Schaltungseinheit 10 mittels eines in FIG 1 nicht dargestellten Temperatursensors erfasst wird. Über eine Wertetabelle werden dann zu einem erfassten Temperaturwert die benötigten Änderungen für die Steuerwerte D1 und D2 ausgelesen. Die Wertetabelle ist in dem Controller gespeichert. Sie ist bei der Herstellung der Schaltungseinheit 10 vom Hersteller durch Messversuche erstellt worden. Anders als beim Stand der Technik sind keine zusätzlichen Rechnungen zum Ändern des Datenwerts D in jedem Ausgabezyklus des Controllers notwendig, um eine Veränderung der Kennlinie zu kompensieren.

In einer anderen Ausführungsform der Schaltungseinheit werden die Steuerwerte D1, D2 auf andere Weise nachgeführt. Dabei ist der Controller mit Mitteln zum Erfassen der Ausgangsspannung ausgestattet. In regelmäßigen Abständen, beispielsweise jede Minute, vergleicht der Controller die zu einem Datenwert tatsächlich von der Schaltungseinheit erzeugte Ausgangsspannung mit der Ausgangsspannung, wie die sich gemäß einer gewünschten Kennlinie ergeben müsste. Anhand mehrerer solcher Vergleiche und einer dabei gemessenen Abweichung ist es möglich, durch den Controller die Steuerwerte automatisch nachführen zu lassen.

In einer weiteren Ausführungsform der erfindungsgemäßen Schaltungseinheit werden mehrere Ausgangsbereiche bereitgestellt, d.h. im laufenden Betrieb wird zwischen wenigstens zwei gewünschten Kennlinien gewechselt. Dies wird dadurch bewirkt, dass die Steuerwerte D1 und D2 geändert werden. Damit sind sofort die Kalibrierwerte ebenso wie der Ausgabebereich, d.h. die gewünschte Spanne zwischen minimaler und maximaler Ausgangsspannung V, eingerechnet. Durch diese von einer erfindungsgemäßen Schaltungseinheit ermöglichte Anpassung der Kennlinie, beispielsweise durch Halbieren der Steuerwerte D1 und D2, ergibt sich der Vorteil, dass der Digital-Analog-Wandler 12 durchgehend mit voller Auflösung ohne sonstige Einschränkungen betrieben werden kann.

In FIG 2 sind in dem Diagramm zwei Kennlinien 30, 32 einer Schaltungseinheit dargestellt. Durch die Kennlinien 30, 32 ist der Zusammenhang zwischen einem digitalen Datenwert D und eine Ausgangsspannung V der Schaltungseinheit beschrieben.

Die Kennlinie 30 ergibt sich durch eine Ausführungsform eines erfindungsgemäßen Verfahrens zum Kalibrieren der Schaltungseinheit. Zum Vergleich ist in FIG 2 die Kennlinie 32 gezeigt, wie sie sich für die nicht-kalibrierte Schaltungseinheit ergibt.

An der Kennlinie 32 ist zu erkennen, dass die Schaltungseinheit ohne eine Kalibrierung eine Versatzspannung Vaz aufweist: Selbst wenn der digitale Datenwert D seinen minimalen Zahlenwert annimmt, weist die Ausgangsspannung V einen Spannungswert Vaz auf, der größer als Null ist.

Durch das Verfahren zum Kalibrieren sind zwei Arbeitspunkte 34, 36 der Schaltungseinheit festgelegt, so dass sich für die Schaltungseinheit insgesamt die gewünschte Kennlinie 30 ergibt. Im ersten Arbeitspunkt 34 ist die Ausgangsspannung V gleich Null, wenn der digitale Datenwert seinen minimalen Zahlenwert annimmt. Dies wird mittels einer Kalibrierspannung erreicht. Die Kalibrierspannung ist dabei abhängig von der gemessenen Versatzspannung Vaz. Angelegt ist die Kalibrierspannung an einer Einheit zum Verstärken, die Teil der Schaltungseinheit ist. Durch die Kalibrierspannung wird das Bezugspotential der Einheit zum Verstärken entsprechend der Versatzspannung Vaz verschoben. Im zweiten Arbeitspunkt 36 nimmt die Ausgangsspannung V einen vorbestimmten Vollaussteuerwert Vaf an, der vorliegend allerdings kleiner als die maximal mögliche, von der Einheit zum Verstärken erzeugbare Ausgangsspannung V ist. Durch den zweiten Arbeitspunkt 36 ist festgelegt, dass der Vollaussteuerwert Vaf ausgegeben wird, wenn der digitale Datenwert D einen Fullscalewert Dfs annimmt. Auch dieser Fullscalewert Dfs ist kleiner als der maximal mögliche Zahlenwert, den der Datenwert D annehmen kann. Der zweite Arbeitspunkt 36 ist damit so bestimmt, dass sich für die Schaltungseinheit eine Übersteuerungsreserve R ergibt. Das bedeutet, dass auch ein Datenwert D an die Schaltungseinheit übergeben werden kann, der größer als der Fullscalewert Dfs ist, ohne dass dadurch ein Digital-Analog-Wandler der Schaltungseinheit oder die Einheit zum Verstärken übersteuert würden.

Zusammenfassend ist anhand der beschriebenen Ausführungsbeispiele gezeigt, wie eine Kennlinie einer analogen Ausgangsstufe an eine gewünschte Kennlinie angepasst werden kann, ohne dabei die Verarbeitungsgeschwindigkeit der Ausgangsstufe zu beeinträchtigen.

**Patentansprüche**

**1.** Vorrichtung zum Erzeugen einer Ausgangsspannung (V) in Abhängigkeit von einem digitalen Datenwert (D) mit

- einer Schaltungseinheit (10) umfassend

* einen ersten Digital-Analog-Wandler (12), der dazu ausgebildet ist, ein analoges Spannungssignal (Va) bereitzustellen, das von dem Datenwert (D) abhängt,
* eine erste steuerbare Spannungsquelle (18), die dazu ausgebildet ist, eine Kalibrierspannung (Vkal) zu erzeugen,
* eine Einheit (14) zum Verstärken, die dazu ausgebildet ist, die Ausgangsspannung (V) zu erzeugen, wobei ein Wert der Ausgangsspannung (V) von dem analogen Spannungssignal (Va) und der Kalibrierspannung (Vkal) abhängt, und
* eine zweite steuerbare Spannungsquelle (20), die dazu ausgebildet ist, eine Referenzspannung (Vref) zu erzeugen, **dadurch gekennzeichnet, dass** die vorrichtung ferner aufweist:

- einen Controller, der dazu vorbereitet ist, einen ersten Steuerwert (D1) und einen zweiten Steuerwert (D2) zu erzeugen, wobei

* der erste Digital-Analog-Wandler (12) dazu ausgebildet ist, eine Amplitude des analogen Spannungssignals (Va) in Abhängigkeit von der Referenzspannung (Vref) zu skalieren,
* die kalibrierspannung (VKAL) von dem ersten steuerwert (D1) abhängt,
* die referenzspannung (VREF) von dem zweiten steuerwert (D2) abhängt,
* der erste Steuerwert (D1) für die erste steuerbare Spannungsquelle (18) derart bestimmt ist, dass bei einem vorgegebenen minimalen digitalen Datenwert (D) ein Betrag einer Differenz zwischen einem Istwert der Ausgangsspannung (v) und einem Sollwert derselben kleiner als ein vorgegebener Wert ist, sodass sich die Kalibrierspannung Vkal durch folgende Gleichung in Abhängigkeit von einem bei vorgegebenem maximalen Datenwert (D) gegebenen Vollaussteuerungswert Vaf der Ausgangsspannung, einem Verstärkungsfaktor G, um den das analoge Spannungssignal (Va) in der Einheit (14) verstärkt wird, einem Wert für eine Übersteuerungsreserve R und einem Offsetfehlerwert Vaz der Schaltungseinheit ergibt:

$$Vkal = (Vaf-(R+1)*Vaz)/(G*R),$$

* der zweite Steuerwert (D2) für die zweite steuerbare Spannungsquelle (20) derart bestimmt ist, dass bei einem vorgegebenen maximalen digitalen Datenwert (D) ein Betrag einer Differenz zwischen einem Istwert der Ausgangsspannung (V) und einem Sollwert derselben kleiner als ein vorgegebener Wert ist, sodass sich die Referenzspannung Vref durch folgende Gleichung in Abhängigkeit von dem Vollaussteuerungswert Vaf der Ausgangsspannung, dem Verstärkungsfaktor G, dem Wert für die Übersteuerungsreserve R und dem Offsetfehlerwert Vaz der Schaltungseinheit ergibt:

$$Vref = (Vaf-Vaz)/(G*R).$$

2. Vorrichtung nach Anspruch 1, wobei

- die erste steuerbare Spannungsquelle (18) ein zweiter Digital-Analog-Wandler ist und
- der erste Steuerwert (D1) für die erste steuerbare Spannungsquelle ein digitaler Steuerwert ist.

3. Vorrichtung nach einem der vorhergehenden Ansprüche, wobei

- die zweite steuerbare Spannungsquelle (20) ein dritter Digital-Analog-Wandler ist und
- der zweite Steuerwert (D2) für die zweite steuerbare Spannungsquelle (20) ein digitaler Steuerwert ist.

4. Vorrichtung nach einem der vorhergehenden Ansprüche, wobei

- die Einheit (14) zum Verstärken einen Differenzverstärker (OV) umfasst, wobei ein Ausgang des Differenzverstärkers (OV) über einen Widerstand (R2) mit einem invertierenden Eingang des Differenzverstärkers (OV) verbunden ist, und
- die erste steuerbare Spannungsquelle (18) über einen weiteren Widerstand (R1) mit dem invertierenden Eingang des Differenzverstärkers (OV) verbunden ist und
- der erste Analog-Digital-Wandler (12) das analoge Spannungssignal (Va) an einem nicht-invertierenden Eingang des Differenzverstärkers (OV) anlegt.

**5.** Verfahren zum Kalibrieren einer Schaltungseinheit (10), die mittels eines ersten Digital-Analog-Wandlers (12) und mittels einer Einheit (14) zum Verstärken und in Abhängigkeit von einem digitalen Datenwert (D) eine Ausgangsspannung (V) erzeugt, wobei der erste Digital-Analog-Wandler (12) ein analoges Spannungssignal (Va) bereitstellt, das von dem digitalen Datenwert abhängt, wobei das Verfahren folgende Schritte umfasst:

1) Übergeben eines Datenwerts (D) an den ersten Digital-Analog-Wandler (12), wobei der Datenwert (D) einen minimalen Zahlenwert eines vorgegebenen Wertebereichs repräsentiert und
2) Erfassen der Ausgangsspannung (V) als Istwert eines Offsetfehlers (Vaz);
3) Übergeben eines geänderten Datenwerts (D) an den ersten Digital-Analog-Wandler (12), wobei der geänderte Datenwert (D) einen maximalen Zahlenwert des vorgegebenen Wertebereichs repräsentiert;
4) Erfassen der Ausgangsspannung (V) als Istwert einer Vollaussteuerung (Vaf);
5) Erzeugen einer Kalibrierspannung (Vkal) mittels ersten steuerbaren Spannungsquelle (18), die dazu ausgebildet ist, die Kalibrierspannung (Vkal) in Abhängigkeit von einem ersten Steuerwert (D1) zu erzeugen, sodass sich die Kalibrierspannung Vkal durch folgende Gleichung in Abhängigkeit von dem bei vorgegebenem maximalen Datenwert (D) gegebenen Vollaussteuerungswert Vaf der Ausgangsspannung, einem Verstärkungsfaktor. G, um den das analoge Spannungssignal (Va) in der Einheit (14) verstärkt wird, einem Wert für eine Übersteuerungsreserve R und dem Offsetfehlerwert Vaz der Schaltungseinheit ergibt:

$$Vkal = (Vaf-(R+1)*Vaz)/(G*R),$$

6) Anlegen der Kalibrierspannung (Vkal) an einen Eingang der Einheit (14) zum Verstärken, wobei die Ausgangsspannung (V) von dem analogen Spannungssignal (Va) und der Kalibrierspannung (Vkal) abhängt;
7) Erzeugen einer Referenzspannung (Vref) mittels einer zweiten steuerbaren Spannungsquelle (20), die dazu ausgebildet ist, die Referenzspannung (Vref) in Abhängigkeit von einem zweiten Steuerwert (D2) zu erzeugen, sodass sich die Referenzspannung Vref durch folgende Gleichung in Abhängigkeit von dem Vollaussteuerungswert Vaf der Ausgangsspannung, dem Verstärkungsfaktor G, dem Wert für die Übersteuerungsreserve R und dem Offsetfehlerwert Vaz der Schaltungseinheit ergibt:

$$Vref = (Vaf-Vaz)/(G*R),$$

8) Anlegen der Referenzspannung (Vref) an einen Eingang des ersten Digital-Analog-Wandlers (12), wobei durch den ersten Digital-Analog-Wandler (12) eine Amplitude des analogen Spannungssignals (Va) in Abhängigkeit von der an den Eingang des ersten Digital-Analog-Wandlers (12) angelegten Referenzspannung (Vref) skaliert wird.

**6.** Verfahren nach Anspruch 5, umfassend die weiteren Schritte:

9) Erfassen eines Temperaturwerts an der Schaltungseinheit (10),
10) Ändern der Kalibrierspannung (Vkal) und/oder der Referenzspannung (Vref) in Abhängigkeit von dem Temperaturwert.

**7.** Regler mit einer analogen Ausgabestufe, wobei die analoge Ausgabestufe eine Schaltungseinheit (10) gemäß einem der Ansprüche 1 bis 4 umfasst und/oder der Regler dazu ausgelegt ist, ein Verfahren gemäß einem der Ansprüche 5 oder 6 durchzuführen.

## Claims

**1.** Apparatus for generating an output voltage (V) as a function of a digital data value (D) comprising

- a switching unit (10) including

• a first digital-to-analogue converter (12), which is embodied so as to provide an analogue voltage signal (Va) which depends on the data value (D),

• a first controllable voltage source (18) which is embodied so as to generate a calibration voltage (Vkal),

• a unit (14) for amplification, which is embodied so as to generate the output voltage (V), with a value of the output voltage (V) depending on the analogue voltage signal (Va) and the calibration voltage (Vkal), and

• a second controllable voltage source (20), which is embodied so as to generate a reference voltage (Vref) **characterised in that** the apparatus further comprises

• a controller, which is prepared so as to generate a first control value (D1) and a second control value (D2), wherein

• the first digital-to-analogue converter (12) is embodied so as to scale an amplitude of the analogue voltage signal (Va) as a function of the reference voltage (Vref),

• the calibration voltage (Vkal) depends on the first control value (D1),

• the reference voltage (Vref) depends on the second control value (D2),

• the first control value (D1) for the first controllable voltage source (18) is determined such that with a predetermined minimal digital data value (D), a sum of a difference between an actual value of the output voltage (V) and a target value of the same is smaller than a predetermined value, such that the calibration voltage Vkal is produced by the following equation as a function of a full scale value Vaf of the output voltage provided with a predetermined maximum data value (D), an amplification factor G, by which the analogue voltage signal (Va) is amplified in the unit (14), a value of an overload reserve R and an offset error value Vaz of the switching unit:

$$Vkal = (Vaf - (R+1)*Vaz)/G*R),$$

• the second control value (D2) for the second controllable voltage source (20) being determined such with a predetermined maximum digital data value (D), a sum of a difference between an actual value of the output voltage (V) and a target value of the same is smaller than a predetermined value, so that the reference voltage Vref is produced by the following equation as a function of the full scale value Vaf of the output voltage, the amplification factor G, the value for the overload reserve R and the offset error value Vaz of the switching unit:

$$Vref = (Vaf-Vaz)/(G*R)$$

2. Apparatus according to claim 1, with

- the first controllable voltage source (18) being a second digital-to-analogue converter and
- the first control value (D1) for the first controllable voltage source being a digital control value.

3. Apparatus according to one of the preceding claims, wherein

- the second controllable voltage source (20) is a third digital-to-analogue converter and
- the second control value (D2) for the second controllable voltage source (20) is a digital control value.

4. Apparatus according to one of the preceding claims, with

- the unit (14) for amplification comprising a differential amplifier (OV), with an output of the differential amplifier (OV) being connected to an inverting input of the differential amplifier (OV) by way of a resistor (R2), and
- the first controllable voltage source (18) being connected to the inverting input of the differential amplifier (OV) by way of a further resistor (R1) and
- the first analogue-to-digital converter (12) applying the analogue voltage signal (Va) to a non-inverting input of the differential amplifier (OV).

5. Method for calibrating a switching unit (10), which generates an output voltage (V) by means of a first digital-to-analogue converter (12) and by means of a unit (14) for amplification and as a function of a digital data value (D), wherein the first digital-to-analogue converter (12) provides an analogue voltage signal (Va), which depends on the digital data value, with the method comprising the following steps:

1) assigning a data value (D) to the first digital-to-analogue converter (12), with the data value (D) representing a minimal numerical value of a predetermined value range and

2) detecting the output voltage (V) as an actual value of an offset error (Vaz);

3) assigning a changed data value (D) to the first digital-to-analogue-converter (12), with the changed data value (D) representing a maximum numerical value of the predetermined value range

4) detecting the output voltage (V) as an actual value of a full scale value (Vaf);

5) generating a calibration voltage (Vkal) by means of the first controllable voltage source (18) which is embodied so as to generate the calibration voltage (Vkal) as a function of a first control value (D1) so that the calibration voltage (Vkal) is produced by the following equation as a function of the full scale value Vaf of the output voltage provided with the predetermined maximum data value (D), an amplification factor G, by which the analogue voltage signal (Va) is amplified in the unit (14), a value for an overload reserve R and the offset error value Vaz of the switching unit:

$$Vkal = (Vaf - (R+1)*Vaz)/G*R),$$

6) applying the calibration voltage (Vkal) to an input of the unit (14) for amplification, with the output voltage (Vkal) depending on the analogue voltage signal (Va) and the calibration voltage (Vkal);

7) generating a reference voltage (Vref) by means of a second controllable voltage source (20), which is embodied so as to generate the reference voltage (Vref) as a function of a second control value (D2) so that the reference voltage Vref is produced by the following equation as a function of the full scale value Vaf of the output voltage, the amplification factor G, the value for the over load reserve R and the offset error value Vaz of the switching unit:

$$Vref = (Vaf-Vaz)/(G*R),$$

8) applying the reference voltage (Vref) to an input of the first digital-to-analogue converter (12), with an amplitude of the analogue voltage signal (Va) being scaled by the first digital-to-analogue converter (12) as a function of the reference voltage (Vref) applied to the input of the first digital-to-analogue converter (12).

6. Method according to claim 5, comprising the further steps:

9) detecting a temperature value on the switching unit (10),

10) changing the calibration voltage (Vkal) and/or the reference voltage (Vref) as a function of the temperature value.

7. Controller with an analogue output stage, with the analogue output stage comprising a switching unit (10) according to one of claims 1 to 4 and/or the controller being configured so as to implement a method according to one of claims 5 or 6.

**Revendications**

1. Dispositif de production d'une tension ( V ) de sortie en fonction d'une valeur ( D ) de donnée numérique, ayant

- une unité ( 10 ) de commutation comprenant

* un premier convertisseur ( 12 ) numérique-analogique, qui est constitué pour mettre à disposition un signal ( Va ) analogique de tension qui dépend de la valeur ( D ) de donnée,
* une première source ( 18 ) de tension, qui peut être commandée et qui est constituée pour produire une tension ( Vkal ) d'étalonnage,
* une unité ( 14 ) d'amplification, qui est constituée pour produire la tension ( V ) de sortie, une valeur de la tension ( V ) de sortie dépendant du signal ( Va ) analogique de tension et de la tension ( Vkal ) d'étalonnage, et
* une deuxième source (20) de tension, qui peut être commandée et qui est constituée pour produire une tension ( Vref ) de référence,

**caractérisé en ce que** le dispositif comprend, en outre,

- une unité de commande, qui est préparée pour produire une première valeur ( D1 ) de commande et une deuxième valeur ( D2 ) de commande, dans lequel

* le premier convertisseur ( 12 ) numérique-analogique est constitué pour mettre à l'échelle une amplitude du signal ( Va ) analogique de tension en fonction de la tension ( Vref ) de référence,
* la première valeur ( D1 ) de commande de la première source ( 18 ) de tension, qui peut être commandée, est déterminée de manière à ce que, pour une valeur (D) de donnée numérique minimum prescrite, une valeur absolue d'une différence entre une valeur réelle de la tension ( V ) de sortie et une valeur de consigne de celle-ci soit plus petite qu'une valeur prescrite, de manière à obtenir la tension Vkal d'étalonnage par l'équation suivante, en fonction d'une valeur Vaf de la tension de sortie de niveau maximum donnée pour une valeur ( D ) de donnée maximum prescrite, d'un facteur G d'amplification, dont le signal ( Va ) de tension est amplifié dans l'unité ( 14 ), d'une valeur pour une réserve R de surrégulation et d'une valeur Vaz d'erreur de décalage de l'unité de commutation :

$$Vkal = ( Vaf-( R+1 )*Vaz )/( G*R ),$$

* la deuxième valeur ( D2 ) de commande de la deuxième source ( 20 ) de tension, qui peut être commandée, est déterminée de manière à ce que, pour une valeur (D) de donnée numérique maximum prescrite, une valeur absolue d'une différence entre une valeur réelle de la tension ( V ) de sortie et une valeur de consigne de celle-ci soit plus petite qu'une valeur prescrite, de manière à obtenir la tension Vref de référence par l'équation suivante, en fonction de la valeur Vaf de niveau maximum de la tension de sortie, du facteur G d'amplification, de la valeur pour la réserve R de surrégulation et de la valeur Vaz d'erreur de décalage de l'unité de commutation :

$$Vref = ( Vaf-Vaz ) / ( G*R ).$$

2. Dispositif suivant la revendication 1, dans lequel

- la première source ( 18 ) de tension, qui peut être commandée, est un deuxième convertisseur numérique-analogique
et
- la première valeur ( D1 ) de commande de la première source de tension, qui peut être commandée, est une valeur de commande numérique.

3. Dispositif suivant l'une des revendications précédentes, dans lequel

- la deuxième source (20) de tension, qui peut être commandée, est un troisième convertisseur numérique-analogique, et
- la deuxième valeur ( D2 ) de commande de la deuxième source de tension, qui peut être commandée, est une valeur de commande numérique.

4. Dispositif suivant l'une des revendications précédentes, dans lequel

- l'unité ( 14 ) d'amplification comprend un amplificateur ( OV ) différentiel, une sortie de l'amplificateur ( OV ) différentiel étant reliée à une entrée inverseuse de l'amplificateur ( OV ) différentiel par une résistance ( R2 ), et
- la première source ( 18 ) de tension, qui peut être commandée, est reliée à l'entrée inverseuse de l'amplificateur ( OV ) différentiel par une autre résistance ( R1 ), et
- le premier convertisseur ( 12 ) analogique-numérique applique le signal ( Va ) de tension analogique à une entrée non inverseuse de l'amplificateur ( OV ) différentiel.

5. Procédé d'étalonnage d'une unité ( 10 ) de commutation qui produit une tension ( V ) de sortie au moyen d'un premier convertisseur ( 12 ) numérique-analogique et au moyen d'une unité ( 14 ) d'amplification et en fonction d'une valeur ( D ) de donnée numérique, le premier convertisseur ( 12 ) numérique-analogique mettant à disposition un signal ( Va ) analogique de tension, qui dépend de la valeur de donnée numérique, le procédé comprenant les stades suivants :

1 ) on transmet une valeur ( D ) de donnée au premier convertisseur ( 12 ) numérique-analogique, la valeur ( D ) de donnée représentant une valeur de comptage minimum d'une plage de valeur prescrite et
2 ) on détecte la tension ( V ) de sortie en tant que valeur réelle d'une erreur ( Vaz ) de décalage ;
3 ) on transmet une valeur ( D ) de donnée modifiée au premier convertisseur ( 12 ) numérique-analogique, la valeur ( D ) de donnée modifiée représentant une valeur de comptage maximum de la plage de valeur prescrite ;
4 ) on détecte la tension ( V ) de sortie en tant que valeur réelle d'une commande ( Vaf ) de niveau maximum ;
5 ) on produit une tension ( Vkal ) d'étalonnage au moyen d'une première source ( 18 ) de tension, qui peut être commandée et qui est constituée pour produire la tension ( Vkal ) d'étalonnage en fonction d'une première valeur ( D1 ) de commande, de manière à obtenir la tension ( Vkal ) d'étalonnage par l'équation suivante en fonction d'une valeur Vaf de niveau maximum donnée pour une valeur ( D ) de donnée maximum prescrite, d'un facteur G d'amplification, dont le signal (Va) de tension est amplifié dans l'unité ( 14 ), d'une valeur pour une réserve R de surrégulation et d'une valeur Vaz d'erreur de décalage de l'unité de commutation :

$$Vkal = ( Vaf - ( R+1 ) * Vaz ) / ( G*R ),$$

6 ) on applique la tension ( Vkal ) d'étalonnage à une entrée de l'unité ( 14 ) d'amplification, la tension ( V ) de sortie dépendant du signal ( Va ) analogique de tension et de la tension ( Vkal ) d'étalonnage ;
7 ) on produit une tension ( Vref ) de référence au moyen d'une deuxième source ( 20 ) de tension, qui peut être commandée et qui est constituée pour produire la tension ( Vref ) de référence en fonction d'une deuxième valeur ( D2 ) de commande, de manière à obtenir la tension Vref de référence par l'équation suivante en fonction de la valeur Vaf de niveau maximum de la tension de sortie, du facteur G d'amplification, de la valeur pour la réserve R de surrégulation et de la valeur Vaz d'erreur de décalage de l'unité de commutation :

$$Vref = ( Vaf - Vaz ) / ( G*R ).$$

8 ) on applique la tension ( Vref ) de référence à une entrée du premier convertisseur ( 12 ) numérique-analogique, dans lequel, par le premier convertisseur ( 12 ) numérique-analogique, on met à l'échelle une amplitude du signal ( Va ) analogique de tension en fonction de la tension ( Vref ) de référence appliquée à l'entrée du premier convertisseur ( 12 ) numérique-analogique.

6. Procédé suivant la revendication 5,
comprenant les stades supplémentaires :

9 ) on relève une valeur de température sur l'unité ( 10 ) de commutation,
10 ) on modifie la tension ( Vkal ) d'étalonnage et/ou la tension ( Vref ) de référence en fonction de la valeur de la température.

7. Régleur ayant un étage analogique de sortie, l'étage analogique de sortie comprenant une unité ( 10 ) de commutation suivant l'une des revendications 1 à 4 et/ou le réglage étant conçu pour effectuer un procédé suivant l'une des revendications 5 ou 6.

FIG 1

FIG 2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 4342983 A

- US 20050001747 A1

**In der Beschreibung aufgeführte Nicht-Patentliteratur**

- **FALCONI et al.** Electronic interfaces. ELSEVIER SEQUOIA S.A, 23. Januar 2007, vol. 121, 295-329